(19) **Europäisches Patentamt / European Patent Office / Office européen des brevets**

(11) **EP 4 671 408 A1**

(12) **EUROPEAN PATENT APPLICATION**
published in accordance with Art. 153(4) EPC

(43) Date of publication:
**31.12.2025   Bulletin 2026/01**

(51) International Patent Classification (IPC):
*C23C 14/34* (2006.01)   *B22F 1/00* (2022.01)
*B22F 1/05* (2022.01)   *B22F 1/07* (2022.01)
*B22F 1/10* (2022.01)   *B22F 1/14* (2022.01)
*B22F 1/107* (2022.01)   *B22F 1/142* (2022.01)
*B22F 1/145* (2022.01)   *B22F 3/02* (2006.01)
*B22F 3/10* (2006.01)   *B22F 9/04* (2006.01)
*B22F 9/20* (2006.01)   *B22F 10/28* (2021.01)
*B22F 10/34* (2021.01)   *B82Y 30/00* (2011.01)
*B82Y 35/00* (2011.01)   *B82Y 40/00* (2011.01)
*C22C 5/00* (2006.01)   *C22C 30/00* (2006.01)

(21) Application number: 24760421.8

(22) Date of filing: **21.02.2024**

(52) Cooperative Patent Classification (CPC):
**B22F 1/00; B22F 1/05; B22F 1/07; B22F 1/10;
B22F 1/107; B22F 1/14; B22F 1/142; B22F 1/145;
B22F 3/02; B22F 3/10; B22F 9/04; B22F 9/20;
B22F 10/28; B22F 10/34; B82Y 30/00;**   (Cont.)

(86) International application number:
**PCT/JP2024/006398**

(87) International publication number:
**WO 2024/177123 (29.08.2024 Gazette 2024/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.02.2023   JP 2023026471
28.06.2023   JP 2023106367
28.06.2023   JP 2023106369**

(71) Applicant: **TANAKA PRECIOUS METAL
TECHNOLOGIES CO., LTD.
Tokyo 103-0025 (JP)**

(72) Inventors:
• **KIMURA, Saori
Isehara-shi, Kanagawa 259-1146 (JP)**
• **KONDO, Yoshie
Hiratsuka-shi, Kanagawa 254-0021 (JP)**

• **NAKAZAWA, Tatsuya
Isehara-shi, Kanagawa 259-1146 (JP)**
• **OGAWA, Kohei
Isehara-shi, Kanagawa 259-1146 (JP)**
• **MAETO, Keisuke
Hiratsuka-shi, Kanagawa 254-0021 (JP)**
• **HORIKAWA, Tomu
Hiratsuka-shi, Kanagawa 254-0021 (JP)**
• **YAMADA, Takashi
Hiratsuka-shi, Kanagawa 254-0021 (JP)**
• **MIYAMOTO, Hiroshi
Hiratsuka-shi, Kanagawa 254-0021 (JP)**
• **TAKEHARA, Masahiko
Hiratsuka-shi, Kanagawa 254-0021 (JP)**
• **HOSOI, Takuya
Hiratsuka-shi, Kanagawa 254-0021 (JP)**

(74) Representative: **Scott, Stephen John
YUJA IP LAW
East Coast House
25 Skeldergate
York YO1 6DH (GB)**

(54) **SPUTTERING TARGET AND METHOD FOR PRODUCING SAME**

(57)   Provided is a sputtering target having a high level of compositional uniformity. The sputtering target is formed of a noble metal alloy that is formed of 5 or more noble metal elements and exhibits an X-ray diffraction spectrum in which a number of peaks observed in a diffraction angle $2\theta$ range of 38° to 44° is 1.

EP 4 671 408 A1

# FIG. 1

```
┌─────────────────────────────────────┐
│     Raw material preparation step    │
└─────────────────────────────────────┘
                  │
                  ▼
┌─────────────────────────────────────┐
│        Slurry production step        │
└─────────────────────────────────────┘
                  │
                  ▼
┌─────────────────────────────────────┐
│             Mixing step              │
└─────────────────────────────────────┘
                  │
                  ▼
┌─────────────────────────────────────┐
│           First firing step          │
└─────────────────────────────────────┘
                  │
                  ▼
┌─────────────────────────────────────┐
│     First acetic acid treatment step │
└─────────────────────────────────────┘
                  │
                  ▼
┌─────────────────────────────────────┐
│          First washing step          │
└─────────────────────────────────────┘
```

(52) Cooperative Patent Classification (CPC): (Cont.)
B82Y 35/00; B82Y 40/00; C22C 5/00; C22C 30/00;
C23C 14/34

**Description**

TECHNICAL FIELD

The present disclosure relates to a sputtering target and a method of producing the same.

BACKGROUND

In sputtering, which is one type of physical vapor deposition method, ions of Ar or the like are caused to collide with a target to thereby enable deposition of a thin film formed of a constituent material of the target on a substrate. By using a target containing a plurality of components in this sputtering, it is possible to form a thin film formed of a plurality components through a single deposition treatment. Therefore, sputtering is used in the production of thin films having various compositions.

Examples of representative methods of producing a target used in sputtering include a melting method and a sintering method. The melting method is a method that involves melting a raw material, subsequently solidifying the raw material, and then forming a target through plastic forming or machining. The sintering method is a method that involves sintering a raw material in a powdered form to form a target. In particular, the sintering method is widely used because it is applicable even for high melting point materials. In a situation in which a target that contains a plurality of components is to be produced by the sintering method, a plurality of raw material powders may be mixed and subsequently sintered (for example, Patent Literature (PTL) 1 to 3).

Moreover, the formation of thin films formed of noble metals is also typically performed in the field of physical vapor deposition. Particularly in recent years, alloy thin films that contain two or three noble metal elements have been formed through deposition by sputtering (for example, PTL 4 and 5).

Examples of noble metal elements include gold (Au), silver (Ag), platinum (Pt), palladium (Pd), rhodium (Rh), iridium (Ir), ruthenium (Ru), and osmium (Os). Although these elements belong to a single group referred to as the noble metal elements, these elements differ from one another in terms of actual physical and chemical characteristics. Moreover, noble metal alloys formed of these noble metal elements are known to have significantly different characteristics depending on the composition thereof. For this reason, there is anticipation that thin films formed of noble metal alloys may have various characteristics according to the composition thereof.

Furthermore, in recent years, there has been ongoing research related to high-entropy alloys (HEAs) formed of noble metals. Although the meaning of high-entropy alloy varies depending on the definition that is adopted, the term "high-entropy alloy" according to a narrow definition refers to an alloy that contains roughly equiatomic quantities of 5 or more elements and in which a single phase solid solution is formed. High-entropy alloys are attracting attention due to displaying significantly different properties to typical alloys. High-entropy alloys in which base metal elements such as Cr, Mn, Fe, Co, and Ni are used have conventionally been more common, but there are also instances in which high-entropy alloys are synthesized from only noble metal elements (for example, Non-Patent Literature (NPL) 1).

CITATION LIST

Patent Literature

PTL 1: JP 2014-041682 A
PTL 2: JP 2014-098206 A
PTL 3: JP 2024-010347 A
PTL 4: JP 2000-109943 A
PTL 5: JP 2006-228688 A

Non-Patent Literature

NPL 1: Journal of the American Chemical Society, February 2022, Vol. 144, No. 8, p.3365-3369

SUMMARY

(Technical Problem)

As mentioned above, multicomponent noble metal alloys that are formed of multiple noble metal elements have been attracting interest. Therefore, it would be beneficial for a thin film formed of a multicomponent noble metal alloy to be formable by sputtering.

However, since characteristics of a noble metal alloy change significantly depending on the composition thereof as previously described, the presence of variation in the alloy composition of a thin film means that variation also arises in the characteristics of the thin film. Therefore, there is demand for a noble metal alloy thin film having a high level of compositional uniformity in order that characteristics of the noble metal alloy are sufficiently displayed.

In particular, it is considered to be desirable to reduce compositional non-uniformity to as great an extent as possible when producing a thin film formed of a high-entropy alloy such as previously described. In other words, the presence of compositional non-uniformity in a thin film means that the condition of inclusion of an equiatomic quantity of each element is not satisfied in the portion where there is non-uniformity, and thus it may not be possible to obtain the original characteristics of the high-entropy alloy. Moreover, there are instances in which a single phase solid solution cannot be formed when there is high compositional non-uniformity. Therefore, there is demand for significantly higher compositional uniformity than typical conventional alloys.

In order to produce a noble metal alloy thin film having such an extremely uniform composition, it is necessary to eliminate factors causing non-uniformity of composition as much as possible. Consequently, there is also demand for a target used in sputtering to have a high level of compositional uniformity.

However, the inventors discovered as a result of studies that it is difficult to achieve a high level of compositional uniformity such as described above when a sputtering target formed of a multicomponent noble metal alloy is produced by a conventional method.

An object of the present disclosure is to solve the problems set forth above and provide a sputtering target having a high level of compositional uniformity.

(Solution to Problem)

The inventors conducted studies to achieve the object set forth above. As a result, the inventors made the following findings.

(1) When a target is produced by mixing and sintering a plurality of powders formed of different noble metal elements, compositional non-uniformity remains in the target. This is thought to be due to insufficient progression of alloying of the noble metal elements.
(2) When a target is produced by a melting method using a plurality of powders formed of different noble metal elements as raw materials, compositional non-uniformity also remains in the target.
(3) In contrast, when a noble metal alloy powder that has been uniformly alloyed such as to satisfy a specific condition in advance is sintered, compositional non-uniformity in a target can be prevented even in a situation in which 5 or more noble metal elements are included. A target obtained through this method has an extremely uniform composition.

The present disclosure was completed based on the findings described above, and the primary features thereof are as follows.

1. A sputtering target comprising a noble metal alloy, wherein the noble metal alloy:

is formed of 5 or more noble metal elements; and
exhibits an X-ray diffraction spectrum in which a number of peaks observed in a diffraction angle $2\theta$ range of 38° to 44° is 1.

2. The sputtering target according to the foregoing 1, wherein a coefficient of variation CV of content measured by energy dispersive X-ray spectroscopy is 0.2 or less for each of the noble metal elements.

3. A method of producing a sputtering target formed of a noble metal alloy, comprising:

an alloy powder preparation step of preparing an alloy powder as a raw material; and
a sintering step of sintering the alloy powder, wherein
the alloy powder:

is a noble metal alloy powder formed of an alloy of 5 or more noble metal elements;
has an average particle diameter of 0.1 $\mu$m to 100 $\mu$m; and
exhibits an X-ray diffraction spectrum in which a number of peaks observed in a diffraction angle $2\theta$ range of 38° to 44° is 1.

(Advantageous Effect)

According to the present disclosure, it is possible to provide a sputtering target formed of an alloy of 5 or more noble metals that has excellent compositional uniformity.

BRIEF DESCRIPTION OF THE DRAWINGS

In the accompanying drawings:

FIG. 1 is a flow chart illustrating a method of producing a raw material (noble metal alloy powder) in one embodiment of the present disclosure; and
FIG. 2 is a flow chart illustrating a method of producing a raw material (noble metal alloy powder) in another embodiment of the present disclosure.

DETAILED DESCRIPTION

The following provides a specific description of embodiments of the present disclosure. It should be noted that the present disclosure is not limited to the embodiments described below.

[Sputtering target]

A sputtering target in one embodiment of the present disclosure is a sputtering target that is formed of a noble metal alloy. The noble metal alloy is an alloy formed of 5 or more noble metal elements and satisfies the following condition.

- X-ray diffraction spectrum in which the number of peaks observed in a diffraction angle $2\theta$ range of 38° to 44° is 1

• Noble metal elements

Any noble metal elements can be used without any specific limitations as the constituent noble metals of the noble metal alloy. In other words, the noble metal alloy is an alloy formed of 5 or more elements selected from the group consisting of Au, Ag, Pt, Pd, Rh, Ir, Ru, and Os.
Note that among the noble metal elements mentioned above, Os has a property of readily volatilizing upon heating in a production process. Therefore, from a viewpoint of ease of production, it is preferable that the noble metal alloy is an alloy formed of 5 or more elements selected from the group consisting of Au, Ag, Pt, Pd, Rh, Ir, and Ru.
The number of constituent noble metal elements of the alloy should be 5 or more, but no specific limitations are placed on the upper limit for the number of constituent noble metal elements. In other words, all 8 of the noble metal elements may be included. The number of noble metal elements may be 6 or may be 7.
The proportion (content) of each noble metal element contained in the noble metal alloy is not specifically limited and can be set as any value. For example, when a sputtering target that is formed of a high-entropy alloy such as previously described is to be produced, the proportions of noble metal elements contained in the noble metal alloy should be roughly equal values. Specifically, $\Delta C$, which is defined as the difference (Cmax - Cmin) between a largest content (Cmax) and a smallest content (Cmin) among contents (atom%) of all noble metal elements contained in the noble metal alloy, is preferably 10.0 atom% or less, more preferably 5.0 atom% or less, even more preferably 3.0 atom% or less, and most preferably 2.0 atom% or less. On the other hand, the lower $\Delta C$ is the better, and the lower limit may be 0 atom%.

• Number of peaks in XRD spectrum: 1

In a situation in which noble metal elements contained in the noble metal alloy are not sufficiently alloyed, a plurality of peaks originating from the various elements are observed in a diffraction angle $2\theta$ range of 38° to 44° in an X-ray diffraction spectrum. Therefore, in the present disclosure, the number of peaks observed in the range set forth above is stipulated as 1. When the number of peaks in the XRD spectrum is 1, uniform alloying can be said to have been achieved. Note that the reason that the diffraction angle $2\theta$ range in which the number of peaks is counted is set as 38° to 44° is that peaks for noble metal elements (Au, Ag, Pt, Pd, Rh, Ir, Ru, and Os) are observed in this range.

• Coefficient of variation CV of content measured by EDX

In the present disclosure, the coefficient of variation CV of content measured by energy dispersive X-ray spectroscopy (EDX) is preferably 0.2 or less, and more preferably 0.15 or less for each of the constituent noble metal elements of the noble metal alloy. Note that when the coefficient of variation CV is said to be 0.2 or less, this means that the coefficient of variation CV of content of each of the constituent noble metal elements of the noble metal alloy is 0.2 or less. According to the present disclosure, it is possible to obtain a fired product of a noble metal alloy that is extremely uniform such that the coefficient of variation CV is 0.2 or less. On the other hand, no specific limitations are placed on the lower limit for the coefficient of variation CV because the lower the coefficient of variation CV is the better. Typically, the coefficient of variation CV may be 0.05 or more, or may be 0.08 or more.

When the coefficient of variation CV of content measured by EDX satisfies the condition set forth above, even more uniform alloying can be said to have been achieved.

• Crystallite size

No specific limitations are placed on the crystallite size of the constituent noble metal alloy of the sputtering target according to the present disclosure. However, a smaller crystallite size results in higher smoothness of a thin film obtained by sputtering. This can also inhibit the formation of particles during sputtering. Therefore, the crystallite size of the constituent noble metal alloy of the sputtering target is preferably 140 nm or less, more preferably 100 nm or less, and even more preferably 50 nm or less. On the other hand, the lower limit for the crystallite size is not specifically limited but may typically be 1 nm or more, may be 10 nm or more, or may be 20 nm or more.

The crystallite size can be determined from the full width at half maximum of a diffraction peak obtained through X-ray diffraction (XRD) measurement.

Note that the term "sputtering target" as used in the present disclosure refers to a target material that is used in sputtering. Accordingly, the sputtering target serving as a target material can have a backing plate bonded thereto to obtain a sputtering target assembly. In other words, a sputtering target assembly in another embodiment of the present disclosure includes the sputtering target set forth above as a target material and a backing plate bonded to the sputtering target.

[Production method]

Next, a method of producing a sputtering target in one embodiment of the present disclosure is described.

The sputtering target according to the present disclosure can be produced by a sintering method. In other words, a method of producing a sputtering target in one embodiment of the present disclosure includes an alloy powder preparation step and a sintering step. The following provides a specific description of each step. Note that matter that is not specifically mentioned can be performed in accordance with typical sputtering target production techniques.

[Alloy powder preparation step]

First, an alloy powder is prepared as a raw material. The alloy powder is a noble metal alloy powder formed of an alloy of 5 or more noble metal elements and is required to satisfy the following conditions.

• Average particle diameter of 0.1 $\mu$m to 100 $\mu$m
• X-ray diffraction spectrum in which the number of peaks observed in a diffraction angle $2\theta$ range of 38° to 44° is 1

• Average particle diameter: 0.1 $\mu$m to 100 $\mu$m

When the average particle diameter of the alloy powder is less than 0.1 $\mu$m, the apparent density noticeably decreases. A low powder apparent density is not suitable for producing a target because this results in extremely large contraction (reduction of volume) when sintering is performed. Therefore, the average particle diameter is set as 0.1 $\mu$m or more. On the other hand, when the average particle diameter is larger than 100 $\mu$m, a target that is ultimately obtained becomes brittle. Therefore, the average particle diameter is set as 100 $\mu$m or less, preferably 80 $\mu$m or less, more preferably 50 $\mu$m or less, even more preferably 20 $\mu$m or less, and most preferably 10 $\mu$m or less.

• Number of peaks in XRD spectrum: 1

In order that a target that is ultimately obtained exhibits an X-ray diffraction spectrum in which the number of peaks observed in a diffraction angle $2\theta$ range of 38° to 44° is 1, it is necessary for the number of peaks observed in a diffraction angle $2\theta$ range of 38° to 44° to also be 1 for the alloy powder.

• Coefficient of variation CV of content measured by EDX

The coefficient of variation CV of content measured by energy dispersive X-ray spectroscopy (EDX) is preferably 0.2 or less, and more preferably 0.15 or less for each of the constituent metal elements of the noble metal alloy powder. Note that when the coefficient of variation CV is said to be 0.2 or less, this means that the coefficient of variation CV of content of each of the constituent noble metal elements of the noble metal alloy powder is 0.2 or less. By using a powder having a coefficient of variation CV of 0.2 or less as the alloy powder, it is possible to also set the coefficient of variation CV as 0.2 or less in a target that is ultimately obtained. No specific limitations are placed on the lower limit for the coefficient of variation CV because the lower the coefficient of variation CV is the better. Typically, the coefficient of variation CV may be 0.05 or more, or may be 0.08 or more.

• Crystallite size: 60 nm or more

No specific limitations are placed on the crystallite size of the alloy powder that is used as a raw material. However, the use of an alloy powder having a large crystallite size as a raw material reduces contraction in the production process of the target and facilitates shaping. Therefore, the crystallite size of the alloy powder is preferably set as 60 nm or more, and more preferably set as 80 nm or more. On the other hand, the upper limit for the crystallite size is not specifically limited but may typically be 140 nm or less, or may be 120 nm or less. Note that a noble metal alloy powder having a large crystallite size such as described above can be produced by a subsequently described method.

The crystallite size can be determined from the full width at half maximum of a diffraction peak obtained through X-ray diffraction (XRD) measurement.

No specific limitations are placed on the method by which the alloy powder is prepared. In one embodiment of the present disclosure, a noble metal alloy powder produced by a method described below can be used as the alloy powder. Note that the production method disclosed here can be broadly classified as two methods: a method in which firing is only performed once; and a method in which firing is performed a plurality of times. The former is a method that is suitable for producing a powder having a comparatively small average particle diameter, whereas the latter is a method that is suitable for producing a powder having a comparatively large average particle diameter. Each of these production methods is described below.

• Production of powder having comparatively small average particle diameter

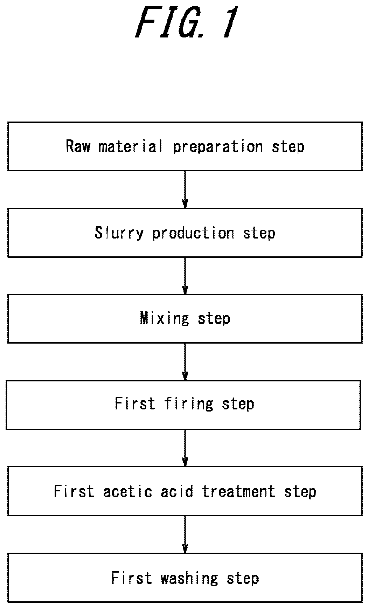

FIG. 1 is a flow chart illustrating a method of producing a noble metal alloy powder in one embodiment of the present disclosure. As illustrated in FIG. 1, the method of producing a noble metal alloy powder in one embodiment of the present disclosure includes the following steps (1) to (6). Through this production method, it is possible to produce a noble metal alloy powder having an average particle diameter of roughly 10 $\mu$m or less. The following provides a specific description of each step.

　　　(1) Raw material preparation step
　　　(2) Slurry production step
　　　(3) Mixing step
　　　(4) First firing step
　　　(5) First acetic acid treatment step
　　　(6) First washing step

This production method is suitable for producing a powder having a comparatively small average particle diameter. Specifically, this production method is suitable for producing a powder having an average particle diameter of approximately 10 $\mu$m or less, is more suitable for producing a powder having an average particle diameter of 5 $\mu$m or less, and is even more suitable for producing a powder having an average particle diameter of 3 $\mu$m or less. The following provides a specific description of each step.

(1) Raw material preparation step

First, in the raw material preparation step, powders (raw material powders) that are to be used as raw materials for producing a noble metal alloy powder are prepared. A raw material powder is prepared separately for each of the constituent noble metal elements of the noble metal alloy that is to ultimately be produced. For example, in a case in which a five-component alloy is to be produced, 5 raw material powders should be prepared.

Although no specific limitations are placed on the particle diameter of the raw material powders, it is preferable to use fine raw material powders from a viewpoint of making the noble metal alloy powder that is ultimately obtained even more uniform. Specifically, the average particle diameter of each raw material powder that is used is preferably set as 1,000 nm or less, more preferably set as 500 nm or less, and even more preferably set as 100 nm or less. On the hand, the lower limit for the average particle diameter is not specifically limited and may be 1 nm or more, may be 5 nm or more, or may be 10 nm or more, for example.

Note that the average particle diameter of the raw material powder referred to here is defined as indicating the average particle diameter d that is determined from the specific surface area of the raw material powder using a perfect sphere model. The average particle diameter d ($\mu$m) is generally referred to as the BET diameter and, more specifically, can be calculated from the density $\rho$ (g/cm$^3$) of constituent particles of the raw material powder and the BET specific surface area s (m$^2$/g) by the following formula (1).

$$d = 6/\rho s \cdots (1)$$

Each raw material powder may be a metal powder or a metal oxide powder. For example, in the case of Pt, not only can Pt powder be used, but also platinum oxide ($PtO_2$) powder can be used. Likewise, oxide powders such as rhodium oxide ($RhO_2$, $RhO_3$) and palladium oxide (PdO) can freely be used. These oxide powders undergo thermal decomposition during firing to function as noble metal sources. Since there is fundamentally no change in terms of function as a raw material between a case in which a metal powder is used and a case in which a metal oxide powder is used, a metal powder or metal oxide powder should be selected according to ease of acquisition of the powder, etc.

However, in the case of Ru, it is preferable to use metal ruthenium powder as a raw material rather than ruthenium oxide ($RuO_2$) powder.

For example, in one embodiment of the present disclosure, it is preferable to use 5 or more types of powders selected from the group consisting of gold, silver, silver oxide, platinum, platinum oxide, palladium, palladium oxide, rhodium, ruthenium, rhodium oxide, iridium, iridium oxide, and osmium as raw material powders.

(2) Slurry production step

Next, the raw material powders, calcium carbonate, and water are mixed to obtain a slurry and the pH of the slurry is set as 8.0 or higher. The calcium carbonate thermally decomposes and at least some thereof is converted to calcium oxide in the firing step. Calcium carbonate and calcium oxide have an effect of impairing grain growth of a noble metal alloy, and thus contribute to micronization of the noble metal alloy powder that is ultimately obtained.

Although no specific limitations are placed on the additive amount of the calcium carbonate, the additive amount as a weight ratio relative to all raw material powders is preferably set as 0.1 times or more, more preferably set as 0.2 times or more, and even more preferably set as 0.5 times or more from a viewpoint of enhancing the above-described effect. On the other hand, although no specific limitations are placed on the upper limit for the additive amount, the effect reaches saturation when there is excessive addition. Consequently, the additive amount as a weight ratio relative to all raw material powders is preferably set as 10 times or less, more preferably set as 5 times or less, and even more preferably set as 2 times or less.

The calcium carbonate can be added in any form. Calcium carbonate powder is typically used. In a case in which calcium carbonate powder is used, the average particle diameter of the calcium carbonate powder is not specifically limited but is preferably set as 0.2 $\mu$m to 1.0 $\mu$m. Note that the average particle diameter of the calcium carbonate referred to here is defined as indicating the average particle diameter d that is determined from the specific surface area of the calcium carbonate using a perfect sphere model. The average particle diameter d ($\mu$m) is generally referred to as the BET diameter and, more specifically, can be calculated from the density $\rho$ (g/cm$^3$) of constituent particles of the calcium carbonate and the BET specific surface area s (m$^2$/g) by the following formula (1).

$$d = 6/\rho s \cdots (1)$$

pH: 8.0 or higher

It is important that the pH of the slurry is set as 8.0 or higher in the slurry production step. When the pH of the slurry is lower than 8.0, compositional uniformity decreases and the coefficient of variation CV in EDX measurement increases in the noble metal alloy powder that is ultimately obtained. Moreover, when the pH of the slurry is lower than 8.0, the number of peaks observed in a diffraction angle 2$\theta$ range of 38° to 44° in an XRD spectrum cannot be set as 1.

No specific limitations are placed on the method by which the pH of the slurry is adjusted. For example, in a situation in which the pH is lower than 8.0, the pH may be adjusted through addition of an alkali to the slurry. The pH can be adjusted by, for example, adding one or more selected from the group consisting of an alkali metal hydroxide, an alkaline earth metal hydroxide, and ammonia to the slurry. The alkali metal hydroxide may be sodium hydroxide or potassium hydroxide, for example. The alkaline earth metal hydroxide may be calcium hydroxide, for example. Note that the pH of the slurry may be measured using a typical pH meter.

No specific limitations are placed on the upper limit for the pH of the slurry. However, the effect of yielding a more uniform alloy reaches saturation when the pH is higher than 10. Moreover, adjustment of the pH to higher than 10 requires the addition of a large amount of an alkali. This may result in a large amount of sodium, potassium, or the like that has been added as the alkali remaining as an impurity. Moreover, in a situation in which ammonia is used as the alkali, this is hazardous because it causes the evolution of a large amount of harmful ammonia gas in the production process. Therefore, it is preferable that the pH of the slurry is set as 10 or lower.

(3) Mixing step

In the mixing step, the slurry is mixed. The mixing can be performed using any mixer without any specific limitations. The mixer may be a ball mill, a planetary mill (planetary ball mill), a bead mill, an attritor, or the like, for example. From a viewpoint of more uniform mixing, it is preferable to use a bead mill or a planetary mill, of which, a bead mill is preferable.

(4) First firing step

Next, the slurry that has been mixed in the mixing step is fired in a non-oxidizing atmosphere to obtain an alloy powder. By obtaining the alloy powder through firing in the present disclosure, it is possible to achieve a higher purity than in a case in which a wet reduction method is adopted. The firing can be performed by any device without any specific limitations. An electric furnace can typically be used.

The first firing step is performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

The firing temperature in the first firing step (first firing temperature) is not specifically limited and can be set as any temperature so long as it is a temperature at which the powders can be fired. The preferred first firing temperature is dependent on the melting point $T_M$ determined by the composition of the used noble metal alloy. From a viewpoint of promoting diffusion of the raw material powders and further increasing crystallinity, the first firing temperature $T_1$ is preferably set as not lower than $T_L$ defined by the following formula. On the other hand, although no specific limitations are placed on the upper limit for the first firing temperature, an excessively high first firing temperature may result in the occurrence of necking between alloy particles and the formation of coarse powder. Therefore, the first firing temperature $T_1$ is preferably set as not higher than $T_H$ defined by the following formula.

$$T_L \ (^{\circ}C) = T_M \ (K) \times 0.55 - 273.15$$

$$T_H \ (^{\circ}C) = T_M \ (K) \times 0.77 - 273.15$$

$T_M$ referred to here is taken to be a weighted average of the melting points of all of the constituent noble metal elements of the noble metal alloy. The contents (mass%) of the noble metal elements are used to calculate this weighted average.

The firing time in the first firing step is not specifically limited but is preferably set as 1 hour or more from a viewpoint of alloy grain growth. On the other hand, the firing time is preferably set as 5 hours or less from a viewpoint of production efficiency.

(5) First acetic acid treatment step

Next, a fired material that has been obtained through the first firing step is treated with acetic acid. The acetic acid treatment enables removal of calcium that is contained in the fired material. Note that in a situation in which an acid other than acetic acid (for example, hydrochloric acid or nitric acid) is used, not only calcium, but also noble metal elements dissolve, resulting in reduction of uniformity of the alloy. In contrast, dissolution of noble metal elements is not a concern with acetic acid irrespective of the concentration. Therefore, it is important that acetic acid is used for removal of calcium in the present disclosure.

Although no specific limitations are placed on the method of acetic acid treatment, the acetic acid treatment may typically be performed by stirring the fired material in an acetic acid aqueous solution to cause dissolution of calcium that is contained in the fired material. The acetic acid treatment can be performed any number of times so long as it is performed at least once. From a viewpoint of reducing the amount of calcium remaining as an impurity as much as possible, the acid treatment is preferably performed at least twice, and is more preferably performed at least three times. In a case in which the acetic acid treatment is performed a plurality of times, a new acetic acid aqueous solution may be used each time the acetic acid treatment is performed.

In the acetic acid treatment, the fired material may be loaded into an acetic acid aqueous solution that has been prepared in advance, or the fired material may first be loaded into pure water, and then acetic acid may be added to the pure water.

The following describes a specific example of a suitable acetic acid treatment method.

First, the fired material is loaded into pure water and is stirred. This converts calcium oxide that is contained in the fired material to calcium hydroxide. Next, acetic acid is further added and stirred therewith to cause dissolution of the calcium hydroxide. Thereafter, stirring is stopped, settling is performed to cause sedimentation of powder, and then the supernatant is removed. The above corresponds to one repetition of acetic acid treatment. Thereafter, further addition and stirring of pure water and acetic acid, settling, and supernatant removal are repeated twice.

(6) First washing step

Next, the fired material (alloy powder) after the acetic acid treatment is water washed and dried (washing step). The water washing removes acid and also calcium that is in a dissolved state in the acid.

The water washing is preferably performed using pure water. No specific limitations are placed on the method by which the water washing is performed. For example, after removal of the supernatant in the acetic acid treatment, washing can be performed through addition and stirring of pure water. After the stirring has been stopped, settling is performed to cause sedimentation of powder, and then the supernatant is removed. The water washing is preferably repeated at least twice, and is more preferably repeated at least three times. After water washing, it is preferable that water and powder are separated by filtration and that the obtained powder is subjected to subsequent drying.

The drying can be performed by any method so long as it is a method by which water can be removed. Although natural drying may be used, heated drying is preferable in order to efficiently remove water. In the case of heated drying, the heating temperature is not specifically limited but is preferably set as 50°C or higher, and is more preferably set as 80°C or higher. The heating temperature may be 100°C or higher. The drying time is also not specifically limited and can be set as any time according to the amount of powder that is to be dried. From a viewpoint of sufficient drying, the drying time is preferably set as 1 hour or more, and is more preferably set as 5 hours or more. The drying time may be 10 hours or more. On the other hand, although no specific limitations are placed on the upper limit for the heating time, an upper limit of 100 hours or less is typically preferable, and an upper limit of 50 hours or less is typically more preferable.

Note that after drying, the resultant noble metal alloy powder is preferably further subjected to sieving. This makes it possible to break up particles that have aggregated in the process of washing.

Through the procedure set forth above, it is possible to obtain a noble metal alloy powder having a comparatively small particle diameter (specifically, an average particle diameter of 10 $\mu$m or less).

• Production of powder having comparatively large average particle diameter

The following describes a method of producing a noble metal alloy powder in another embodiment of the present disclosure. The production method of the present embodiment is a method that is suitable for producing a comparatively large powder having an average particle diameter of up to 100 $\mu$m. Specifically, this production method is suitable for producing a powder having an average particle diameter of more than 5 $\mu$m, and is more suitable for producing a powder having an average particle diameter of more than 10 $\mu$m.

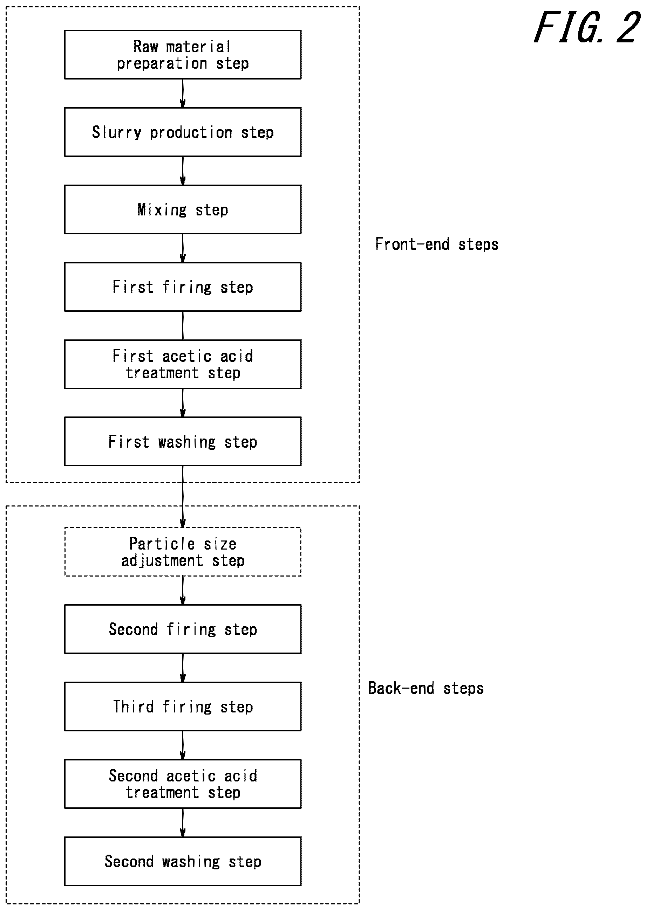

FIG. 2 is a flow chart illustrating the method of producing a noble metal alloy powder in the present embodiment. As illustrated in FIG. 2, a method of producing a noble metal alloy powder in one embodiment of the present disclosure further includes the following steps (7) to (10) in addition to steps (1) to (6) in the embodiment illustrated in FIG. 1. Moreover, a particle size adjustment step can optionally be performed before the second firing step.

(7) Second firing step
(8) Third firing step
(9) Second acetic acid treatment step
(10) Second washing step

However, of steps (7) to (10) listed above, only the second firing step (7) is an essential step and the remaining steps (8) to (10) are steps that can optionally be performed. In other words, the method of producing a noble metal alloy powder in the present embodiment can be broadly classified as two methods: a method in which a noble metal alloy powder is obtained through steps (1) to (7); and a method in which a noble metal alloy powder is obtained through steps (1) to (10). In the former of these methods, firing is performed twice (first firing step and second firing step). In the latter of these methods, firing is performed three times (first firing step, second firing step, and third firing step).

Note that for convenience of description, steps from the raw material preparation step to the first washing step are referred to as "front-end steps" and steps from the second firing step onwards are referred to as "back-end steps". Moreover, a particle size adjustment step may be further included after the first washing step and before the second firing step. In a case in which a particle size adjustment step is implemented, the particle size adjustment step is considered to be included among back-end steps as illustrated in FIG. 2.

In the present embodiment, a powder having high crystallinity and excellent compositional uniformity is first produced in the front-end steps. However, the powder that is obtained at this stage is composed of comparatively small particles (primary particles) having an average particle diameter of roughly 10 $\mu$m or less. Moreover, these primary particles aggregate with one another to form roughly spherical aggregates (secondary particles), and these secondary particles have a particle diameter of the order of tens of micrometers to a hundred micrometers. By further performing treatment of back-end steps with respect to this powder, it is possible to set the average particle diameter as more than 10 $\mu$m and not more than 100 $\mu$m while maintaining high crystallinity and compositional uniformity.

• Particle size adjustment step

In the back-end steps, the particle size of the alloy powder after the first washing step may be adjusted (particle size adjustment step) prior to the subsequent second firing step. By performing particle size adjustment, a noble metal alloy powder having a desired particle size can be obtained more easily. The particle diameter of the noble metal alloy powder that is ultimately obtained is roughly equal to the particle diameter of the powder after particle size adjustment (i.e., the powder that is subjected to the subsequent second firing step). Accordingly, in the particle size adjustment step, the particle size should be adjusted in accordance with the desired particle diameter of the noble metal alloy powder that is to ultimately be obtained.

Although no specific limitations are placed on the method by which the particle size is adjusted, the particle size adjustment may typically be performed through sieving of the alloy powder. Any sieve can be used without any specific limitations. Note that powder that has passed through the sieve (passed material) or powder that has not passed through the sieve (retained material) can be used. Moreover, the particle size of the alloy powder may be adjusted by performing sieving twice or more. For example, coarse grains in the alloy powder may first be removed using a first sieve and then the powder may be adjusted to a desired particle size using a subsequent sieve.

Sieving of the alloy powder can also yield an effect of spheroidization of powder particles in addition to the effect of particle size adjustment. This is thought to be due to alloy powder in the form of aggregates being subjected to mechanical force such as vibration, rolling, and friction on the sieve, thereby reducing unevenness of particle surfaces. Although the effect of spheroidization described above is obtained both for passed material and retained material, the effect is more noticeable for retained material. Therefore, from a viewpoint of enhancing the spheroidization effect, it is preferable that at least once in the particle size adjustment step, the alloy powder is sieved and powder that has not passed through the sieve (retained material) is used.

• Second firing step

Next, the alloy powder is subjected to second firing (second firing step). Note that in a case in which particle size adjustment is not performed, the alloy powder after the first washing step should be subjected to second firing, whereas in a case in which particle size adjustment is performed, the alloy powder after particle size adjustment should be subjected to second firing. Prior to the firing, the secondary particles are brittle and are easily broken up by physical contact or shock. Accordingly, performing second firing causes necking between primary particles forming the secondary particles and fixes the state of the particles.

It should be noted that although calcium carbonate is used to impair necking between secondary particles in the subsequent third firing step, mixing with calcium carbonate without the second firing breaks up aggregation of the secondary particles and makes it difficult to control the particle size because the secondary particles are brittle prior to the firing as described above. Therefore, by stabilizing the structure of the secondary particles by performing second firing and subsequently mixing the secondary particles with calcium carbonate, it is possible to suitably control the particle size.

The temperature while the second firing is performed (second firing temperature) is not specifically limited and can be set as any temperature at which sintering between primary particles occurs. The preferred second firing temperature is dependent on the melting point $T_M$ determined by the composition of the used noble metal alloy. Therefore, the second firing temperature $T_2$ is preferably set as not lower than $T_L$ and not higher than $T_H$ defined by the following formulae.

$$T_L \ (°C) = T_M \ (K) \times 0.45 - 273.15$$

$$T_H \ (^\circ C) = T_M \ (K) \times 0.60 - 273.15$$

$T_M$ referred to here is taken to be a weighted average of the melting points of all of the constituent noble metal elements of the noble metal alloy. The contents (mass%) of the noble metal elements are used to calculate this weighted average.

The time for which the second firing is performed (second firing time) is not specifically limited but is preferably set as 5 hours or less, and more preferably set as 2 hours or less. Moreover, the second firing time is preferably set as 30 minutes or more, more preferably set as 40 minutes or more, and even more preferably set as 50 minutes or more.

The second firing step is performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

In one embodiment of the present disclosure, the alloy powder that has been obtained through the second firing step can be used as a raw material in production of a sputtering target. Alternatively, the alloy powder can be further subjected to the following treatment.

• Third firing step

The alloy powder after the second firing is further fired in a non-oxidizing atmosphere (third firing step). By performing two stages of firing in this manner, it is possible to cause stronger bonding between the constituent primary particles of the secondary particles and to further increase the sphericity of particles. The firing can be performed by any device without any specific limitations. An electric furnace can typically be used.

In the third firing step, firing is performed in a mixed state with calcium carbonate serving as a sintering inhibitor in order to prevent bonding of secondary particles to one another to form coarse particles. The additive amount and form of the calcium carbonate are not specifically limited and can be the same as in the previously described first firing step.

The third firing step is performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

The firing temperature in the third firing step (third firing temperature) is not specifically limited and can be set as any temperature so long as it is a temperature at which the powder can be fired. The preferred third firing temperature is dependent on the melting point $T_M$ determined by the composition of the used noble metal alloy. The third firing temperature $T_3$ is preferably set as not lower than $T_L$ defined by the following formula. On the other hand, although no specific limitations are placed on the upper limit for the third firing temperature, an excessively high third firing temperature may result in the occurrence of necking between alloy particles and the formation of coarse powder. Therefore, the third firing temperature $T_3$ is preferably set as not higher than $T_H$ defined by the following formula.

$$T_L \ (^\circ C) = T_M \ (K) \times 0.55 - 273.15$$

$$T_H \ (^\circ C) = T_M \ (K) \times 0.77 - 273.15$$

$T_M$ referred to here is taken to be a weighted average of the melting points of all of the constituent noble metal elements of the noble metal alloy. The contents (mass%) of the noble metal elements are used to calculate this weighted average.

The firing time in the third firing step is not specifically limited but is preferably set as 1 hour or more. On the other hand, the firing time is preferably set as 5 hours or less from a viewpoint of production efficiency.

• Second acetic acid treatment step

Next, the alloy powder (fired material) after the third firing step is treated with acetic acid (second acetic acid treatment step). The acetic acid treatment enables removal of calcium that is contained in the fired material. Note that in a situation in which an acid other than acetic acid (for example, hydrochloric acid or nitric acid) is used, not only calcium, but also noble metal elements dissolve, resulting in reduction of uniformity of the alloy. In contrast, dissolution of noble metal elements is not a concern with acetic acid irrespective of the concentration. Therefore, it is important that acetic acid is used for removal of calcium in the present disclosure.

The conditions of the second acetic acid treatment step are not specifically limited and can be the same as in the previously described first acetic acid treatment step.

• Second washing step

The alloy powder after the second acetic acid treatment is water washed and dried (second washing step). The water washing enables removal of acetic acid and also calcium that is in a dissolved state in the acetic acid. The conditions of the second washing step are not specifically limited and can be the same as in the previously described first washing step.

Through the treatment set forth above, it is possible to obtain a noble metal alloy powder satisfying the previously described conditions.

[Sintering step]

Next, the alloy powder that has been prepared in the alloy powder preparation step is sintered to obtain a target (sintering step). The sintering can be performed by any method without any specific limitations. When performing the sintering, it is preferable that the alloy powder is heated and that the alloy powder is also pressed. The pressing may be performed concurrently with heating, may be performed prior to heating, or may be performed at both of these times. No specific limitations are placed on the method by which pressing is performed. For example, the alloy powder can be pressed in a state in which it has been loaded into a mold. The pressing may be performed in just a uniaxial direction or may be performed isotropically. For example, the sintering can be performed by hot press sintering, hot isostatic pressing (HIP), or spark plasma sintering (SPS).

The conditions during sintering are not specifically limited and should be adjusted according to the noble metal alloy powder that is used. For example, bonding among the powder does not sufficiently progress when the sintering temperature is too low. Therefore, the sintering temperature $T_S$ in the sintering step is preferably set as not lower than $T_L$ defined by the following formula. On the other hand, although no specific limitations are placed on the upper limit for the sintering temperature, the effect reaches saturation when the sintering temperature is excessively high. Therefore, the sintering temperature $T_S$ is preferably set as not higher than $T_H$ defined by the following formula.

$$T_L \ (°C) = T_M \ (K) \times 0.51 - 273.15$$

$$T_H \ (°C) = T_M \ (K) \times 0.86 - 273.15$$

$T_M$ referred to here is taken to be a weighted average of the melting points of all of the constituent noble metal elements of the noble metal alloy. The contents (mass%) of the noble metal elements are used to calculate this weighted average.

Heating to the sintering temperature can be performed at any rate. For example, the time taken until the sintering temperature is reached from the start of heating (heat-up time) may be 30 minutes to 240 minutes, or may be 60 minutes to 180 minutes.

Once the sintering temperature has been reached, it is preferable that this temperature is held. The time for which the sintering temperature is held is not specifically limited but is preferably set as 30 minutes or more, and more preferably set as 1 hour or more. On the other hand, the effect reaches saturation when the sintering temperature is held for an excessively long time. Therefore, the holding time is preferably set as 5 hours or less, and more preferably set as 4 hours or less.

The sintering step is preferably performed in a non-oxidizing atmosphere in order to prevent oxidation of components. Any atmosphere that is non-oxidizing can be adopted as the non-oxidizing atmosphere without any specific limitations. Typically, a nitrogen gas atmosphere, an argon gas atmosphere, an atmosphere formed of hydrogen gas and nitrogen gas, an atmosphere formed of hydrogen gas and argon gas, or the like can be used. From a viewpoint of reliably preventing oxidation of raw material, it is preferable to use an atmosphere that is formed of hydrogen gas and nitrogen gas or that is formed of hydrogen gas and argon gas.

The sintering can be performed using any heating device. For example, an electric furnace can be used. It is preferable that an electric furnace that includes a means of controlling an atmosphere inside of the furnace is used as the electric furnace.

Processing or polishing may be performed after the sintering step. In other words, a method of producing a sputtering target in one embodiment of the present disclosure can optionally include either or both of a processing step and a polishing step after the sintering step.

EXAMPLES

The following provides a more specific description of effects according to the present disclosure through examples and comparative examples of the present disclosure, but the present disclosure in not limited thereto.

[Example 1]

• Alloy powder preparation step

First, a five-component noble metal alloy powder formed of Ru, Rh, Pd, Ir, and Pt was produced by the following procedure.

Powders of Pt, Pd, $IrO_2$, Ru, and Rh were prepared as raw material powders. Among these powders, Pt black, Pd black, and Rh black were respectively used as powders of Pt, Pd, and Rh. Moreover, the Ru powder was produced through reduction of $RuO_2$ powder.

The raw material powders were mixed with calcium carbonate powder and water to obtain a slurry. During mixing, an alkali for pH adjustment was added as necessary in order to set the pH of the slurry as a value shown in Table 1. The additive amount of the calcium carbonate was set as a weight ratio of 0.8 times relative to the total amount of the raw material powders. Moreover, the water was pure water used in a weight ratio of 2 times relative to the total of the raw material powders and the calcium carbonate.

Next, the slurry was mixed in a planetary ball mill. The mixing conditions were set as a rotation speed of 200 rpm and a mixing time of 6 hours. Moreover, a polyamide pot was used as a mixing vessel and polyamide balls of 10 mm in diameter were used as media.

The slurry after mixing was fired in an $N_2/H_2$ atmosphere to obtain an alloy powder. Specifically, the slurry was first dried at 130°C in a dryer to remove water and obtain a mixed powder. Next, the mixed powder was loaded into a crucible and was fired. The firing was performed using an atmosphere-type heating electric furnace. The atmosphere during firing was set as a 3% $H_2$/97% $N_2$ gas atmosphere, the firing temperature was set as 1300°C, and the firing time was set as 5 hours.

Next, the alloy powder that was obtained through the firing step was subjected to acetic acid treatment and was subsequently washed with pure water and dried.

(Acetic acid treatment)

The acetic acid treatment was performed three times by the following procedure. First, the fired material (alloy powder) was loaded into pure water and was stirred. This converted calcium oxide contained in the fired material to calcium hydroxide. Next, acetic acid was further added and stirred therewith to cause dissolution of the calcium hydroxide. Thereafter, stirring was stopped, settling was performed to cause sedimentation of powder, and then the supernatant was removed. The above corresponds to one repetition of acetic acid treatment. Thereafter, further addition and stirring of pure water and acetic acid, settling, and supernatant removal were repeated twice.

Next, washing with pure water was performed three times by the following procedure. First, once the supernatant had been removed in the third repetition of acetic acid treatment, pure water was added and stirred. After the stirring had been stopped, settling was performed to cause sedimentation of powder, and then the supernatant was removed. Three repetitions of the washing described above were performed.

(Drying)

After the washing, water and powder were separated by filtration, and the obtained powder was dried. The drying was performed at 130°C for 12 hours.

The powder after drying was sieved to cause disintegration of aggregated powder. A test sieve made of stainless steel that had an opening size of 125 $\mu$m was used as the sieve. Note that all particles passed through the sieve without remaining on the sieve.

Next, the average particle diameter, the crystallite size, the number of peaks in an XRD spectrum, and the coefficient of variation CV in EDX were measured by the following procedures with respect to the obtained noble metal alloy powder. The measurement results are shown in Table 1.

(Average particle diameter)

The average particle diameter of the obtained noble metal alloy powder was measured using a laser diffraction particle size analyzer MT-3000 produced by MicrotracBEL Corp. Specifically, the alloy powder was added to a sodium hexametaphosphate aqueous solution that circulated inside of the particle size analyzer, was dispersed for 1 minute by ultrasonication, and then a particle size distribution was measured. The determined 50% particle diameter (D50) by volume was taken to be the average particle diameter of the noble metal alloy powder.

(Crystallite size)

The crystallite size of the obtained noble metal alloy powder was measured by an X-ray diffractometer Ultima IV produced by Rigaku Corporation. In this measurement, the powder serving as a measurement subject was loaded into a glass cell for powder measurement to obtain a sample. The measurement conditions were set as a Cu target, a tube voltage of 40 kV, a tube current of 40 mA, a scan range of 10° to 100°, a sampling interval of 0.02°, and a scan speed of 30°/min. The crystallite size was calculated by the Scherrer equation from the full width at half maximum of a diffraction peak obtained through the measurement.

(Number of peaks in XRD spectrum)

With respect to the XRD spectrum obtained in measurement of crystallite size described above, the number of peaks observed in a diffraction angle $2\theta$ range of 38° to 44° was determined. Note that in counting of the number of peaks, peak separation of XRD peaks was performed by Gaussian fitting, and peaks having a peak width of at least 0.1° and also having a peak intensity of at least 1/100th of that of the maximum peak were regarded as peaks.

(Coefficient of variation CV in EDX)

The coefficient of variation CV of content of each noble metal element contained in the obtained noble metal alloy powder was calculated from measurement results of energy dispersive X-ray spectroscopy. This measurement was performed using a scanning electron microscope (SEM)-energy dispersive X-ray analyzer (EDX) JSM-6010LA produced by JEOL Ltd. and with the alloy powder fixed on carbon tape as a measurement sample. The measurement conditions were set as a magnification of ×3,000 and an accelerating voltage of 20 kV. EDX quantitative measurement was performed at 30 randomly selected points under these conditions to determine the content of each noble metal element. The coefficient of variation CV was calculated from the average and standard deviation of the determined contents.

It can be seen from the results shown in Table 1 that a noble metal alloy powder having high crystallinity and excellent compositional uniformity was obtained through the procedure described above.

[Table 1]

| Powder no. | Noble metal alloy powder (raw material) | | | | | | | | |
|---|---|---|---|---|---|---|---|---|---|
| | Production conditions | Measurement results | | | | | | | |
| | pH | Average particle diameter ($\mu$m) | Crystallite size (nm) | XRD number of peaks | EDX coefficient of variation | | | | |
| | | | | | Ru | Rh | Pd | Ir | Pt |
| Noble metal alloy powder 1 | 9.0 | 1.1 | 90.7 | 1 | 0.148 | 0.106 | 0.132 | 0.133 | 0.100 |

• Sintering step

Next, the obtained noble metal alloy powder was sintered to produce a sputtering target. In this example, the sintering was performed by hot press sintering. The specific procedure was as follows.

First, 238 g of the noble metal alloy powder was loaded into a sintering mold made of graphite. The internal shape of the sintering mold was 80 mm × 80 mm. Next, the powder in the sintering mold was hot pressed in a nitrogen atmosphere under conditions of a temperature of 1100°C, a pressure of 15.5 MPa, and a holding time of 30 minutes. After being left to cool, a sputtering target was taken out of the sintering mold.

In cutting of the obtained sputtering target using a commercially available automatic cutting machine, cutting was possible without any problem. An end surface after the cutting had metallic luster. Moreover, it was possible to polish the sputtering target by a typical method, and the polished surface had metallic luster. Since the sputtering target according to the present disclosure can be processed and polished by typical methods in this manner, the sputtering target can also be considered suitable as a target material from this viewpoint.

Next, the crystallite size, the number of peaks in an XRD spectrum, and the coefficient of variation CV in EDX were measured by the following procedures with respect to the obtained sputtering target. The measurement results are shown in Table 2.

(Crystallite size)

The crystallite size of the obtained target was measured by an X-ray diffractometer Ultima IV produced by Rigaku Corporation. In this measurement, the target serving as a measurement subject was taken to be a sample. The measurement conditions were set as a Cu target, a tube voltage of 40 kV, a tube current of 40 mA, a scan range of 10° to 100°, a sampling interval of 0.02°, and a scan speed of 30°/min. The crystallite size was calculated by the Scherrer equation from the full width at half maximum of a diffraction peak obtained through the measurement.

(Number of peaks in XRD spectrum)

With respect to the XRD spectrum obtained in measurement of crystallite size described above, the number of peaks observed in a diffraction angle $2\theta$ range of 38° to 44° was determined. Note that in counting of the number of peaks, peak separation of XRD peaks was performed by Gaussian fitting, and peaks having a peak width of at least 0.1° and also having a peak intensity of at least 1/100th of that of the maximum peak were regarded as peaks.

(Coefficient of variation CV in EDX)

The coefficient of variation CV of content of each noble metal element contained in the obtained target was calculated from measurement results of energy dispersive X-ray spectroscopy. This measurement was performed using a scanning electron microscope (SEM)-energy dispersive X-ray analyzer (EDX) JSM-6010LA produced by JEOL Ltd. and with the target fixed on carbon tape as a measurement sample. The measurement conditions were set as a magnification of ×3,000 and an accelerating voltage of 20 kV. EDX quantitative measurement was performed at 30 randomly selected points under these conditions to determine the content of each noble metal element. The coefficient of variation CV was calculated from the average and standard deviation of the determined contents.

[Table 2]

| No. | Sputtering target | | | | | | | | |
|---|---|---|---|---|---|---|---|---|---|
| | Used powder | Production method | Measurement results | | | | | | |
| | | | Crystallite size (nm) | XRD number of peaks | EDX coefficient of variation | | | | |
| | | | | | Ru | Rh | Pd | Ir | Pt |
| Example 1 | Noble metal alloy powder 1 | Hot press sintering | 33.4 | 1 | 0.066 | 0.058 | 0.075 | 0.081 | 0.065 |
| Comparative Example 1 | Mixed powder | Arc melting | - | 4 | 0.245 | 0.072 | 0.531 | 0.303 | 0.193 |
| Comparative Example 2 | Mixed powder | Sintering after kneading | - | 7 | 1.692 | 0.549 | 0.211 | 0.956 | 0.308 |
| Comparative Example 3 | Noble metal alloy powder 1 | Arc melting | - | 2 | 0.186 | 0.049 | 0.399 | 0.239 | 0.155 |

It can be seen from the results shown in Table 2 that a sputtering target having excellent compositional uniformity and high crystallinity was obtained by the procedure described above.

The sputtering target was used to actually perform magnetron sputtering to produce a noble metal alloy powder film. Upon measurement of the coefficient of variation CV in EDX for the obtained film by the same method as in evaluation of the target, the coefficients of variation of Ru, Rh, Pd, Ir, and Pt were respectively 0.135, 0.107, 0.137, 0.149, and 0.112. This result demonstrates that a noble metal alloy film having excellent compositional uniformity can be obtained by using a sputtering target that satisfies the conditions according to the present disclosure. Note that a film obtained by sputtering is normally amorphous. Therefore, an XRD spectrum of the film was not measured.

[Comparative Example 1]

Next, a mixed powder was sintered to produce a sputtering target for the purpose of comparison. The mixed powder was obtained by mixing Ru powder, Rh powder, Pd powder, Ir powder, and Pt powder such that each noble metal element was an equiatomic quantity. The used powder of each element was a chemically reduced powder, and each of the powders had an average particle diameter of approximately hundreds of micrometers to 1 $\mu$m.

After loading 10 g of the mixed powder into a water-cooled copper hearth and completely melting the mixed powder by arc melting, the melt was left to cool to room temperature and was then taken out of the water-cooled copper hearth. The arc melting was performed in an Ar atmosphere. Other conditions were the same as those in Example 1.

The number of peaks in an XRD spectrum and the coefficient of variation CV in EDX were measured with respect to the obtained sputtering target by the same methods as in Example 1. The measurement results are also shown in Table 2. Note that with the target of Comparative Example 1, a plurality of peaks were observed in the XRD spectrum used for calculation of crystallite size. Therefore, the crystallite size cannot be unambiguously determined and is not shown in Table 2.

In Comparative Example 1 in which the mixed powder was used, the number of peaks in the XRD spectrum was 4 as shown in Table 2, which indicates that uniform alloying was not possible. Moreover, values for the coefficient of variation CV in EDX were significantly larger than those in Example 1. This also indicates that compositional uniformity is poor. Although each powder is temporarily melted and mixed in the arc melting method, it is not possible to obtain a target having a uniform composition in a situation in which a mixed powder is used.

[Comparative Example 2]

The same mixed powder as in Comparative Example 1 was sintered to produce a sputtering target. However, the target was produced by the following procedure in Comparative Example 2 in order to more uniformly mix the powders of the elements.

Specifically, the mixed powder, a resin, and a solvent were first mixed into the form of a paste. The contents of the mixed powder, the resin, and the solvent in the paste were set respectively as 80 mass%, 1.8 mass%, and 18.2 mass%. Ethyl cellulose and texanol were used respectively as the resin and the solvent.

Next, the obtained paste was kneaded by a three-roll mill for a sufficient time to cause sufficient dispersion of each component.

Next, the paste was applied as a film onto an alumina substrate by screen printing. Next, drying was performed at 120°C to volatilize the solvent contained in the applied paste and form a thin film. The obtained thin film was peeled from the substrate and was ground in a crucible to obtain a noble metal powder-resin mixed powder in which the noble metal powder and the resin were in a sufficiently uniformly mixed state.

Next, a shaped product (powder compact) was produced by applying pressure to the noble metal powder-resin mixed powder. The shaped product was subsequently sintered at 1300°C to obtain a sintered product (target). Other conditions were the same as those in Comparative Example 1.

The number of peaks in an XRD spectrum and the coefficient of variation CV in EDX were measured with respect to the obtained sputtering target by the same methods as in Example 1. The measurement results are also shown in Table 2. Note that with the target of Comparative Example 2, a plurality of peaks were observed in the XRD spectrum used for calculation of crystallite size. Therefore, the crystallite size cannot be unambiguously determined and is not shown in Table 2.

It can be seen from Table 2 that in Comparative Example 2 in which the mixed powder was used, compositional uniformity was poorer than in Example 1 despite a resin and a solvent being used to perform sufficiently uniform kneading and firing being performed at a sufficiently high temperature of 1300°C.

[Comparative Example 3]

Next, a sputtering target was produced under the same conditions as in Example 1 with the exception that are melting was used instead of hot press sintering for the purpose of comparison. The conditions of arc melting were the same as those in Comparative Example 1.

The number of peaks in an XRD spectrum and the coefficient of variation CV in EDX were measured with respect to the obtained sputtering target by the same methods as in Example 1. The measurement results are also shown in Table 2. Note that with the target of Comparative Example 3, a plurality of peaks were observed in the XRD spectrum used for calculation of crystallite size. Therefore, the crystallite size cannot be unambiguously determined and is not shown in Table 2.

It can be seen from Table 2 that in Comparative Example 3 in which arc melting was used, the number of peaks in the XRD spectrum was 2 and uniform alloying was not possible despite the same noble metal alloy powder 1 as in Example 1 being used as a raw material. It can also be seen that values for the coefficient of variation CV in EDX were significantly larger than those in Example 1. This also indicates that compositional uniformity is poor. The cause of such compositional non-uniformity is thought to be the occurrence of segregation when the alloy that had been temporarily melted was subsequently resolidified.

The results set forth above demonstrate that in order to obtain a sputtering target having excellent compositional uniformity that satisfies the conditions according to the present disclosure, it is necessary to produce the target through sintering of a raw material powder that has been uniformly alloyed in advance.

**Claims**

1.  A sputtering target comprising a noble metal alloy, wherein the noble metal alloy:

    is formed of 5 or more noble metal elements; and
    exhibits an X-ray diffraction spectrum in which a number of peaks observed in a diffraction angle $2\theta$ range of 38° to 44° is 1.

2.  The sputtering target according to claim 1, wherein a coefficient of variation CV of content measured by energy dispersive X-ray spectroscopy is 0.2 or less for each of the noble metal elements.

3.  A method of producing a sputtering target formed of a noble metal alloy, comprising:

    an alloy powder preparation step of preparing an alloy powder as a raw material; and
    a sintering step of sintering the alloy powder, wherein
    the alloy powder:

    is a noble metal alloy powder formed of an alloy of 5 or more noble metal elements;
    has an average particle diameter of 0.1 $\mu$m to 100 $\mu$m; and
    exhibits an X-ray diffraction spectrum in which a number of peaks observed in a diffraction angle $2\theta$ range of 38° to 44° is 1.

# FIG. 1

```
┌─────────────────────────────────────┐
│     Raw material preparation step    │
└─────────────────────────────────────┘
                  │
                  ▼
┌─────────────────────────────────────┐
│        Slurry production step        │
└─────────────────────────────────────┘
                  │
                  ▼
┌─────────────────────────────────────┐
│             Mixing step              │
└─────────────────────────────────────┘
                  │
                  ▼
┌─────────────────────────────────────┐
│           First firing step          │
└─────────────────────────────────────┘
                  │
                  ▼
┌─────────────────────────────────────┐
│    First acetic acid treatment step  │
└─────────────────────────────────────┘
                  │
                  ▼
┌─────────────────────────────────────┐
│          First washing step          │
└─────────────────────────────────────┘
```

FIG. 2

Front-end steps

```
┌─────────────────────────┐
│ Raw material            │
│ preparation step        │
└─────────────────────────┘
           ↓
┌─────────────────────────┐
│ Slurry production step  │
└─────────────────────────┘
           ↓
┌─────────────────────────┐
│ Mixing step             │
└─────────────────────────┘
           ↓
┌─────────────────────────┐
│ First firing step       │
└─────────────────────────┘
           ↓
┌─────────────────────────┐
│ First acetic acid       │
│ treatment step          │
└─────────────────────────┘
           ↓
┌─────────────────────────┐
│ First washing step      │
└─────────────────────────┘
```

Back-end steps

```
┌─────────────────────────┐
│ Particle size           │
│ adjustment step         │
└─────────────────────────┘
           ↓
┌─────────────────────────┐
│ Second firing step      │
└─────────────────────────┘
           ↓
┌─────────────────────────┐
│ Third firing step       │
└─────────────────────────┘
           ↓
┌─────────────────────────┐
│ Second acetic acid      │
│ treatment step          │
└─────────────────────────┘
           ↓
┌─────────────────────────┐
│ Second washing step     │
└─────────────────────────┘
```

## INTERNATIONAL SEARCH REPORT

International application No.

**PCT/JP2024/006398**

### A. CLASSIFICATION OF SUBJECT MATTER

*C23C 14/34*(2006.01)i; *B22F 1/00*(2022.01)i; *B22F 1/05*(2022.01)i; *B22F 1/07*(2022.01)i; *B22F 1/10*(2022.01)i; *B22F 1/14*(2022.01)i; *B22F 1/107*(2022.01)i; *B22F 1/142*(2022.01)i; *B22F 1/145*(2022.01)i; *B22F 3/02*(2006.01)i; *B22F 3/10*(2006.01)i; *B22F 9/04*(2006.01)i; *B22F 9/20*(2006.01)i; *B22F 10/28*(2021.01)i; *B22F 10/34*(2021.01)i; *B82Y 30/00*(2011.01)i; *B82Y 35/00*(2011.01)i; *B82Y 40/00*(2011.01)i; *C22C 5/00*(2006.01)i; *C22C 30/00*(2006.01)i

FI:    C23C14/34 A; B22F1/00 K; B22F1/05; B22F1/07; B22F1/10; B22F1/107; B22F1/14 400; B22F1/142; B22F1/145; B22F3/02 L; B22F3/10 D; B22F9/04 Z; B22F9/20 Z; B22F10/28; B22F10/34; B82Y30/00; B82Y35/00; B82Y40/00; C22C5/00; C22C30/00

According to International Patent Classification (IPC) or to both national classification and IPC

### B. FIELDS SEARCHED

Minimum documentation searched (classification system followed by classification symbols)

C23C14/34; B22F1/00; B22F1/05; B22F1/07; B22F1/10; B22F1/107; B22F1/14; B22F1/142; B22F1/145; B22F3/02; B22F3/10; B22F9/04; B22F9/20; B22F10/28; B22F10/34; B82Y30/00; B82Y35/00; B82Y40/00; C22C5/00; C22C30/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | US 2004/0025986 A1 (PERRY, Andrew C.) 12 February 2004 (2004-02-12)<br>entire text | 1-3 |
| P, A | JP 7300565 B1 (TANAKA KIKINZOKU KOGYO K.K.) 29 June 2023 (2023-06-29)<br>entire text | 1-3 |
| A | WO 2021/020377 A1 (KYOTO UNIVERSITY) 04 February 2021 (2021-02-04)<br>entire text | 1-3 |
| A | WO 2005/056851 A1 (TANAKA KIKINZOKU KOGYO K.K.) 23 June 2005 (2005-06-23)<br>entire text | 1-3 |

☑ Further documents are listed in the continuation of Box C.    ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 April 2024** | **14 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
| --- |
| **PCT/JP2024/006398** |

### C.    DOCUMENTS CONSIDERED TO BE RELEVANT

| Category* | Citation of document, with indication, where appropriate, of the relevant passages | Relevant to claim No. |
| --- | --- | --- |
| A | WO 2021/112004 A1 (MITSUBISHI MATERIALS CORPORATION) 10 June 2021 (2021-06-10) <br> entire text | 1-3 |

Form PCT/ISA/210 (second sheet) (July 2022)

**INTERNATIONAL SEARCH REPORT**
Information on patent family members

International application No.

**PCT/JP2024/006398**

| Patent document cited in search report | | | Publication date (day/month/year) | Patent family member(s) | | | Publication date (day/month/year) |
|---|---|---|---|---|---|---|---|
| US | 2004/0025986 | A1 | 12 February 2004 | (Family: none) | | | |
| JP | 7300565 | B1 | 29 June 2023 | (Family: none) | | | |
| WO | 2021/020377 | A1 | 04 February 2021 | US entire text EP | 2022/0258231 4005701 | A1 A1 | |
| WO | 2005/056851 | A1 | 23 June 2005 | US entire text EP | 2007/0148033 1734140 | A1 A1 | |
| WO | 2021/112004 | A1 | 10 June 2021 | CN entire text KR | 114761609 10-2022-0107192 | A A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014041682 A
- JP 2014098206 A
- JP 2024010347 A
- JP 2000109943 A
- JP 2006228688 A

### Non-patent literature cited in the description

- *Journal of the American Chemical Society*, February 2022, vol. 144 (8), 3365-3369